# EUROPEAN PATENT APPLICATION

(11) **EP 2 398 060 A2**
(43) Date of publication of application: **21.12.2011**
(21) Application number: 11003176.2
(22) Date of filing: 15.04.2011
(51) Int. Cl.: H01L 31/0224, H01L 31/18

(54) **Method of forming electrode and method of manufacturing solar cell using the same**

(30) Priority: 14.06.2010 KR 20100056021
(71) Applicant: Samsung Electronics Co., Ltd., Suwon-si, Gyeonggi-do 442-742 (KR); SAMSUNG SDI CO., LTD., Yongin-si, Gyeonggi-do (KR)
(72) Inventor: Song, Nam-Kyu, Chungcheongnam-do (KR); Oh, Min-Seok, Gyeonggi-do (KR); Park, Min, Seocho-gu, Seoul (KR); Kim, Jung-Tae, Gyeonggi-do (KR); Lee, Yun-Seok, Gangseo-gu, Seoul (KR); Lee, Cho-Young, Gyeonggi-do (KR)
(74) Representative: Taor, Simon Edward William

(57) **Abstract**

A method of forming an electrode, by which the resistance of the electrode can be reduced, and a method of manufacturing a solar cell using the method of forming an electrode are provided. The electrode forming method includes coating conductive paste on a substrate, forming a metal layer by drying the conductive paste or heating the same at low temperature, and annealing the metal layer by Joule heating using the metal layer by applying an electric field to the metal layer.

## Description

### CROSS-REFERENCE TO RELATED APPLICATION

This application claims priority from Korean Patent Application No. 10-2010-0056021 filed on June 14, 2010 in the Korean Intellectual Property Office, the disclosure of which is incorporated herein by reference in its entirety.

### BACKGROUND

### 1. Field of the Invention

The subject matter disclosed herein relates to a method of forming an electrode and a method of manufacturing a solar cell using the same, and more particularly, to a method of forming an electrode, which can reduce the resistance of the electrode, and a method of manufacturing a solar cell using the same.

### 2. Description of the Related Art

In recent years, a reduction in existing energy resources such as petroleum or coal is expected, while worldwide demand for substitute energy is gradually increasing. Particularly, solar cells have received a great deal of attention because they are rich in energy resources without posing a problem of environmental pollution. Solar cells are largely divided into solar thermal cells generating steam power required for rotating a turbin using solar heat, and photovoltaic solar cells converting photons into electric energy using semiconductor properties. Photovoltaic solar cells (herein referred to as solar cellsr) are generally referred to as solar cells.

Power characteristics of a solar cell are generally determined by energy conversion efficiency η, which is obtained by dividing the maximum value Pm of the product, i.e., Ip×Vp, of output current Ip and output voltage Vp of the current-voltage curve, as simulated using a solar simulator, by total solar energy (S×I) of the light incident into the solar cell, where S represents a device area, and I represents the intensity of light irradiated into the solar cell.

In order to improve the conversion efficiency of a solar cell it is necessary to increase reflectivity of the solar cell with respect to sunlight and to suppress recombination of carriers. In addition, it is necessary to lower resistance levels of a semiconductor substrate and an electrode.

### SUMMARY

The present invention provides a method of forming an electrode by which the resistance of the electrode can be reduced.

The present invention also provides a method of manufacturing a solar cell using a method of forming an electrode by which the resistance of the electrode can be reduced.

The above and other objects of the present invention will become apparent from the following description of the preferred embodiments.

According to an aspect of the present invention, there is provided a method of forming an electrode that includes coating conductive paste on a substrate, forming a metal layer by drying the conductive paste or heating the same at low temperature, and annealing the metal layer by Joule heating using the metal layer by applying an electric field to the metal layer.

According to another aspect of the present invention, there is provided a method of manufacturing a solar cell using a method of forming an electrode, the manufacturing method includes coating conductive paste on a first surface of a substrate, forming a metal layer by drying the conductive paste or heating the same at low temperature, and forming a first electrode by annealing the metal layer by Joule heating using the metal layer by applying an electric field to the metal layer.

### BRIEF DESCRIPTION OF THE DRAWINGS

FIGS. 1-4 are perspective views illustrating process steps in a method of forming an electrode according to a first embodiment of the present invention;

FIG. 5 is a perspective view illustrating a method of applying an electric field to a metal layer in a method of forming an electrode according to a second embodiment of the present invention;

FIGS. 6-8 are perspective views of solar cells manufactured by a method of manufacturing the solar cells according to embodiments of the present invention;

FIGS. 9-14 are perspective views illustrating the method of manufacturing the solar cell shown in FIG. 6;

FIGS. 15 and 16 are perspective views illustrating a method of applying an electric field to a metal layer for forming a front surface electrode in a method of manufacturing a solar cell according to a second embodiment of the present invention;

FIG. 17 is a perspective view illustrating a texturing structure formed on a back surface of a light absorbing layer in a method of manufacturing a solar cell according to a third embodiment of the present invention; and

FIGS. 18-21 are perspective views illustrating the method of manufacturing the solar cell shown in FIG. 8.

### DETAILED DESCRIPTION

Advantages and features of the present invention and methods of accomplishing the same may be understood more readily by reference to the following detailed description of preferred embodiments and the accompanying drawings. The present invention may, however, be embodied in many different forms and should not be construed as being limited to the embodiments set forth herein. Rather, these embodiments are provided so that this disclosure will be thorough and complete and will fully convey the concept of the invention to those skilled in the art, and the present invention will only be defmed by the appended claims. In the drawings, the thicknesses of layers and regions are exaggerated for clarity.

As used herein, the singular forms "a", "an" and "the" are intended to include the plural forms as well, unless the context clearly indicates otherwise. It will be further understood that the terms "comprises" and/or "made of," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being "on," or "connected to" another element or layer, it can be directly on or connected to the other element or layer or intervening elements or layers may be present. In contrast, when an element is referred to as being "directly on" or "directly connected to" another element or layer, there are no intervening elements or layers present. As used herein, the term "and/or" includes any and all combinations of one or more of the associated listed items.

Spatially relative terms, such as "below," "beneath," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. Throughout the drawings and written description, like reference numerals will be used to refer to like or similar elements.

Embodiments described herein will be described referring to plan views and/or cross-sectional views by way of ideal schematic views of the invention. Accordingly, the exemplary views may be modified depending on manufacturing technologies and/or tolerances. Therefore, the embodiments of the invention are not limited to those shown in the views, but include modifications in configuration formed on the basis of manufacturing processes. Therefore, regions exemplified in figures have schematic properties and shapes of regions shown in figures exemplify specific shapes of regions of elements and not limit aspects of the invention.

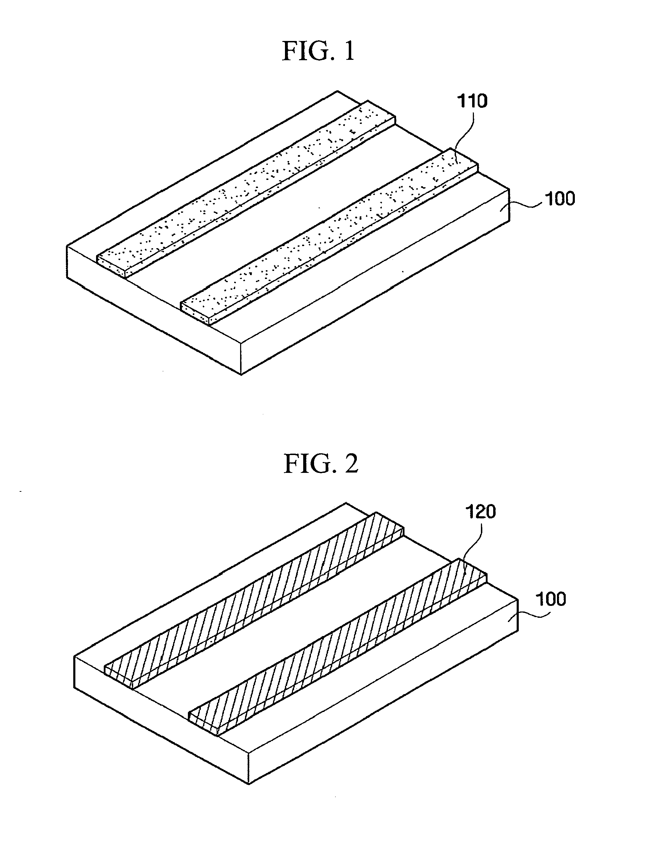

Hereinafter, a method for forming an electrode according to exemplary embodiments of the present invention will be described in detail with reference to FIGS. 1 through 4. FIGS. 1 through 4 are perspective views sequentially illustrating process steps in a method of forming an electrode according to a first embodiment of the present invention.

Referring to FIG. 1, conductive paste 110 is coated on a substrate 100. A composition of the conductive paste 110 is not specifically limited but may include, for example, metal powder, glass frit, and a binder. The metal powder may include a metal having excellent electric conductivity and reflectivity, such as silver (Ag), aluminium (Al), titanium (Ti), alloys of these metals, or the like. The conductive paste 110 is coated on the substrate 100 by, for example, a spin coating method, a slit coating, spray method, a screen printing method, an ink-jet method, a gravure printing method, an off-set printing method, or a dispensing method.

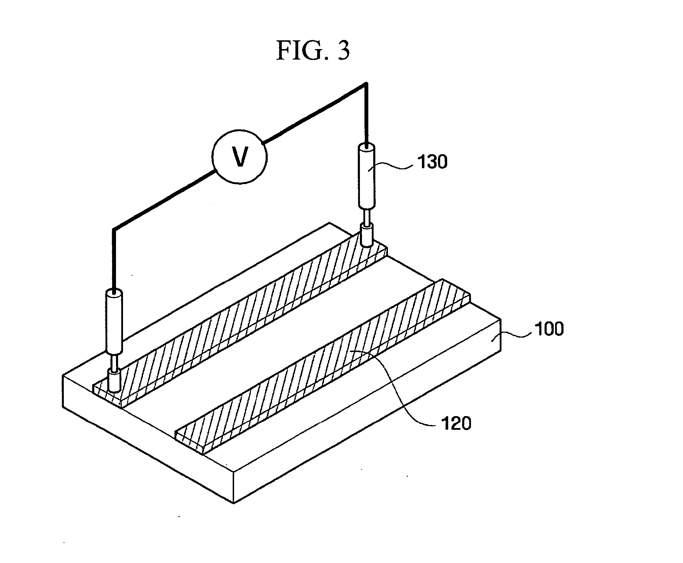

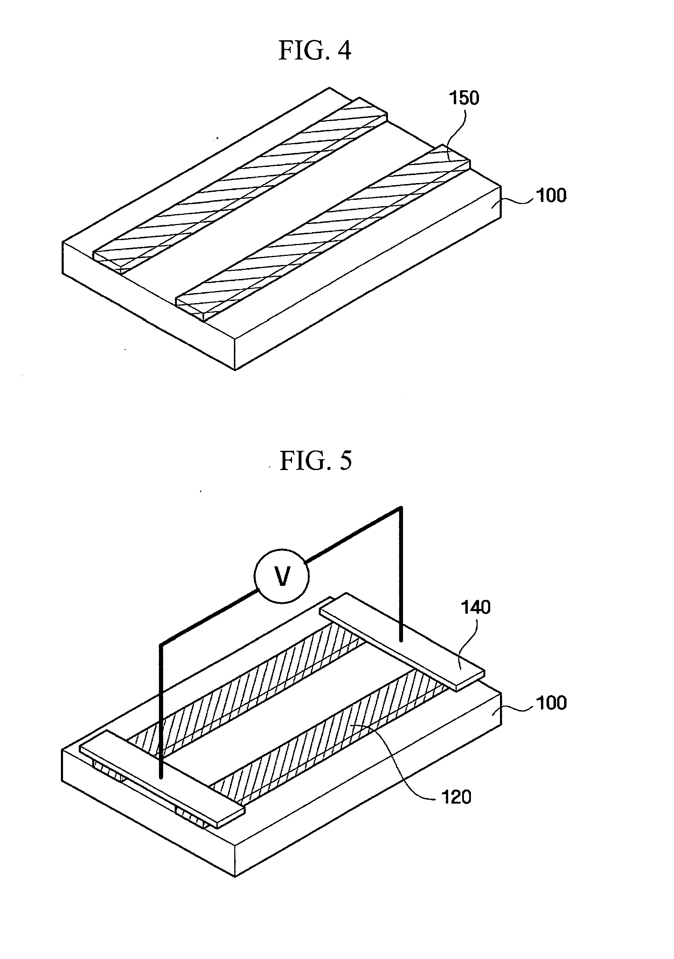

Referring to FIG. 2, the conductive paste 110 is dried or heated at low temperature to form a metal layer 120. After the conductive paste 110 is dried or heated at low temperature conductive paste 110 to be formed as the metal layer 120 in a solid state, an electric field may be applied to the metal layer 120 (Refer to FIGS. 3 and 5.). The conductive paste 110 may be dried or heated at a temperature of approximately 200 or less. The substrate 100 having the conductive paste 110 coated thereon is put into a processing chamber. The conductive paste 110 may also be dried or heated at a temperature by increasing a temperature of the processing chamber.

Referring to FIG. 3, an electric field is applied to the metal layer 120. More specifically, a probe 130 is allowed to contact both ends of the metal layer 120 and the electric field is applied to the metal layer 120 by applying a voltage (V) to the probe 130. If the electric field is applied to the metal layer 120, current flows through the metal layer 120 to generate joule heat. In the electrode forming method according to the present invention, the metal layer 120 is annealed by Joule heating using the joule heat.

An annealing temperature of the metal layer 120 may be adjusted by adjusting the electric field applied to the metal layer 120. The electric field to be applied to metal layer 120 to anneal the metal layer 120 at a desired temperature may vary according to the line width, height, and length of the metal layer 120. For example, if the line width of the metal layer 120 is approximately 4 mm, a voltage applied to the metal layer 120 may be approximately 100 V or less, and current applied to the metal layer 120 may be approximately 5 A or less.

The applying of the electric field to the metal layer 120 may be performed for a very short time ranging from several microseconds (*µ*sec) to several milliseconds (msec). Here, the electric field applied may be general direct-current (DC) power or pulsed DC power. The applying of the pulsed DC is advantageous in that elaborate temperature controlling can be achieved and the substrate 100 formed under the metal layer 120 can be prevented from being damaged.

Referring to FIGS. 3 and 4, the metal layer 120 is annealed by joule heating, thereby completing the electrode 150.

When the electrode 150 is formed using the conductive paste 110, like in the first embodiment of the present invention, the higher the annealing temperature of the conductive paste 110, the less the resistance of the completed electrode 150. For example, if the annealing temperature of the conductive paste 110 is elevated from approximately 170°Cto approximately 220°C, line resistance of the electrode 150 may be reduced by approximately 30 Ω/m to approximately 120 Ω/m. When the temperature of the processing chamber is raised to a high temperature to anneal the conductive paste 110 at high temperature, a bottom portion of the substrate 100 may be damaged due to heat.

In the joule heating, however, the metal layer 120 may be heated at a temperature in a range of approximately 300°Cto approximately 400°C for a very short time ranging from several microseconds (*µ*sec) to several milliseconds (msec). That is to say, based on the joule heating, since heat is applied to the metal layer 120 for a very short time ranging from several microseconds (*µ*sec) to several milliseconds (msec), it is possible to prevent the heat from being transferred to the substrate 100 formed under the metal layer 120, thereby preventing the substrate 100 from being damaged due to the heat.

Meanwhile, the applying of the pulsed DC to the metal layer 120, which allows elaborate temperature controlling, is more advantageous in that the substrate 100 formed under the metal layer 120 can be prevented from being damaged.

Hereinafter, a method of forming an electrode according to a second embodiment of the present invention will be described in detail with reference to FIGS. 1 and 2 and FIGS. 4 and 5. FIG. 5 is a perspective view illustrating a method of applying an electric field to a metal layer in a method of forming an electrode according to a second embodiment of the present invention. The method of forming an electrode according to a second embodiment of the present invention is substantially the same as that according to the first embodiment of the present invention, except for the method of applying an electric field to a metal layer, and the following description is based on differences between the two embodiments.

Referring to FIG. 5, in the electrode forming method according to the second embodiment, a metal plate 140 is allowed to contact both ends of the metal layer 120 and a voltage (V) is applied to the metal plate 140.

Hereinafter, a method of manufacturing a solar cell using the electrode forming method according to the second embodiment will be described in detail with reference to the accompanying drawings.

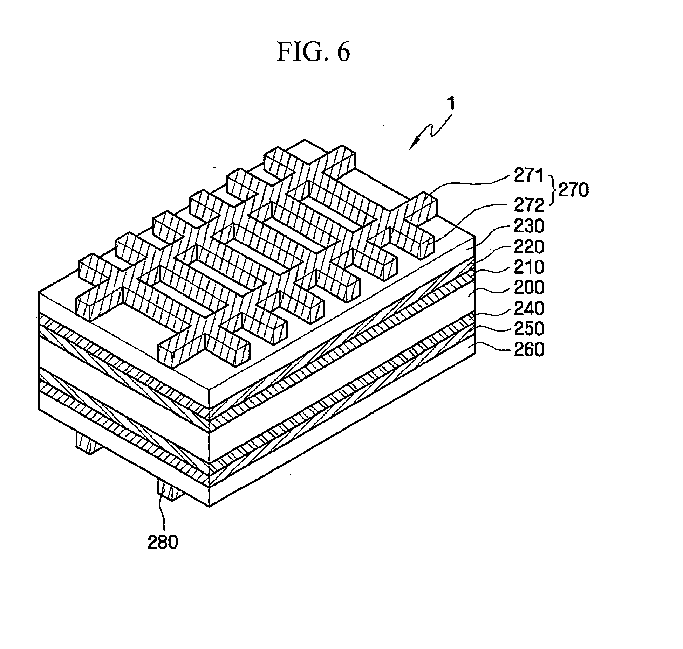

First, solar cells manufactured by a method of manufacturing the solar cells according to embodiments of the present invention will be described with reference to FIGS. 6 through 8.

FIGS. 6 through 8 are perspective views of solar cells manufactured by a method of manufacturing the solar cells according to embodiments of the present invention.

A solar cell 1 shown in FIG. 6 is a HIT (Heterojunction with Intrinsic Thin layer) solar cell. In this embodiment, the invention is described with regard to the HIT solar cell by way of example, but aspects of the present invention are not limited thereto.

Throughout the specification, a front surface means a light-receiving surface of sunlight, and a back surface means a surface facing the front surface. A first or second conductivity type means a P type or an N type. In the following description, for convenience of explanation, it is assumed that the first conductivity type is a P type and the second conductivity type is an N type.

Referring to FIG. 6, the solar cell 1 includes a first intrinsic amorphous silicon layer 210, an amorphous silicon layer 220 of first conductivity type, a first transparent conductive oxide (TCO) layer 230 and a front surface electrode 270 sequentially formed on the front surface of a crystal silicon layer 200 of second conductivity type, and a second intrinsic amorphous silicon layer 240, an amorphous silicon layer 250 of second conductivity type, a second TCO layer 260, and a back surface electrode 280 sequentially formed on the back surface of the crystal silicon layer 200 of second conductivity type.

The crystal silicon layer 200 of second conductivity type may be a single crystalline silicon layer or a polycrystalline silicon layer.

The first and second intrinsic amorphous silicon layers 210 and 240 are nearly pure amorphous silicon layers, which include the same number of electrons and holes. The first intrinsic amorphous silicon layer 210 is formed between the crystal silicon layer 200 of second conductivity type and the amorphous silicon layer 220 of first conductivity type, and the second intrinsic amorphous silicon layer 240 is formed between the crystal silicon layer 200 of second conductivity type and the amorphous silicon layer 250 of second conductivity type, thereby preventing electrons and holes from recombining due to interface defects between the crystal silicon layer 200 of second conductivity type and each of the amorphous silicon layer 220 of first conductivity type and the amorphous silicon layer 250 of second conductivity type. The first and second intrinsic amorphous silicon layers 210 and 240 may be formed to a thickness of approximately 20 to approximately 100.

The amorphous silicon layer 220 of first conductivity type and the amorphous silicon layer 250 of second conductivity type may be formed to a thickness of approximately 30 to approximately 100. The first TCO layer 230 may minimize reflection of the sunlight incident into the front surface of the solar cell 1. The second TCO layer 260 may minimize recombination of charges generated by the sunlight. The first TCO layer 230 may also minimize recombination of charges generated by the sunlight. The first TCO layer 230 and the second TCO layer 260 may be TCO layers made of, for example, indium tin oxide (ITO), indium zinc oxide (IZO), indium tin zinc oxide (ITZO), antimony tin oxide (ATO), or aluminum-doped zinc oxide (AZO). The first TCO layer 230 and the second TCO layer 260 may be formed to a thickness of approximately 800 to 1,0000.

In order to form a light-receiving area of the sunlight, the front surface electrode 270 may have a grid shape. For example, the front surface electrode 270 may include bus bars 271 and finger lines 272. The front surface electrode 270 may be shaped of a grid formed when the bus bars 271 and the finger lines 272 intersect each other.

Like the front surface electrode 270, the back surface electrode 280 may also have a grid shape. In this case, since the back surface electrode 280 is not formed on the light-receiving surface, it is possible to reduce a pitch between grids in order to reduce the resistance. Alternatively, the back surface electrode 280 may also be formed to cover the entire surface of the second TCO layer 260.

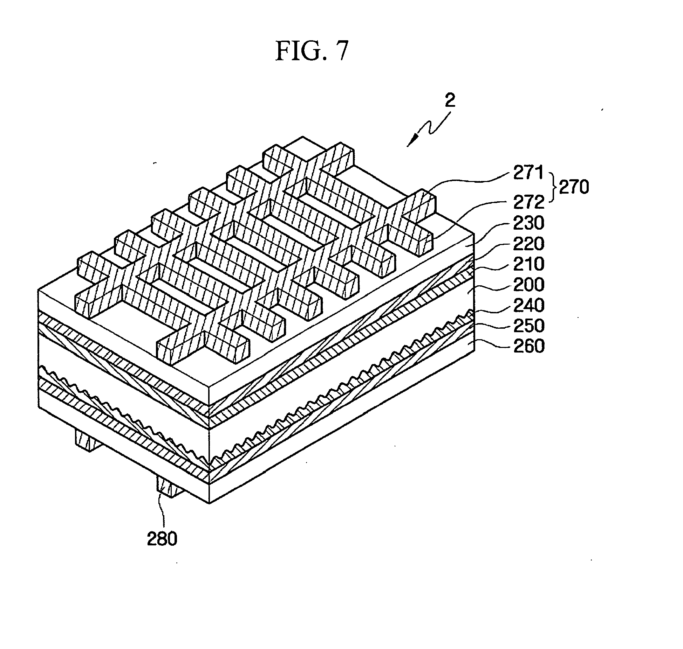

A solar cell 2 shown in FIG. 7 is also an HIT solar cell. The solar cell 2 shown in FIG. 7 is different from the solar cell 1 shown in FIG. 6 in that the back surface of the crystal silicon layer 200 of second conductivity type has a textured structure. Constructing the back surface of the crystal silicon layer 200 of second conductivity type to have a textured structure may further increase the amount of effective light absorbed into the solar cell 2. While FIG. 7 illustrates that the back surface of the crystal silicon layer 200 of second conductivity type, the invention is not limited thereto. The front surface of the crystal silicon layer 200 of second conductivity type or both of the front surface and the back surface of the crystal silicon layer 200 of second conductivity type may have the textured structure.

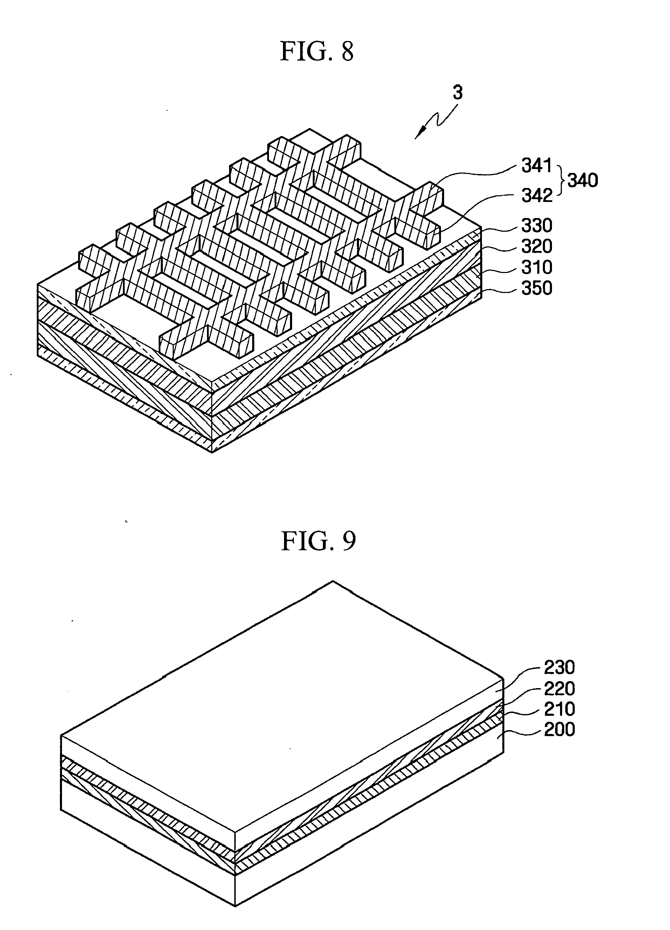

A solar cell 3 shown in FIG. 8 is a crystalline solar cell. In this embodiment, the invention is described with regard to the crystalline solar cell by way of example, but aspects of the present invention are not limited thereto.

Referring to FIG. 8, the solar cell 3 includes a stack of a crystal silicon layer 310 of first conductivity type and a crystal silicon layer 320 of second conductivity type, an anti-reflective layer 330 and a front surface electrode 340 stacked on the front surface of the crystal silicon layer 320 of second conductivity type, and a back surface electrode 350 stacked on the back surface of the crystal silicon layer 310 of first conductivity type.

The crystal silicon layer 310 of first conductivity type and the crystal silicon layer 320 of second conductivity type may be single crystalline silicon layers or polycrystalline silicon layers.

The anti-reflective layer 330 may minimize reflection of the sunlight incident into the front surface of the solar cell 3, and may be made of silicon nitride (SiNx).

In order to form a light-receiving area of the sunlight, the front surface electrode 340 may have a grid shape. For example, the front surface electrode 340 may include bus bars 341 and finger lines 342. The front surface electrode 340 may be shaped of a grid formed when the bus bars 341 and the finger lines 342 intersect each other.

Since the back surface electrode 350 is not formed on the light-receiving surface, it may be formed to cover the entire surface of the crystal silicon layer 310 of first conductivity type in order to reduce the resistance. Alternatively, the back surface electrode 350 may also be grid shaped like the front surface electrode 340.

Hereinafter, methods of manufacturing solar cells according to embodiments of the present invention will be described. First, the method of manufacturing the solar cell shown in FIG. 6 will be described with reference to FIGS. 9 through 14 together with FIG. 6. FIGS. 9 through 14 are perspective views illustrating the method of manufacturing the solar cell shown in FIG. 6.

Referring first to FIG. 9, a first intrinsic amorphous silicon layer 210, an amorphous silicon layer 220 of first conductivity type, and a first TCO layer 230 are sequentially formed on the front surface of the crystal silicon layer 200 of second conductivity type. The forming of the first intrinsic amorphous silicon layer 210, the amorphous silicon layer 220 of first conductivity type and the first TCO layer 230 may be performed using plasma enhanced chemical vapor deposition (PECVD).

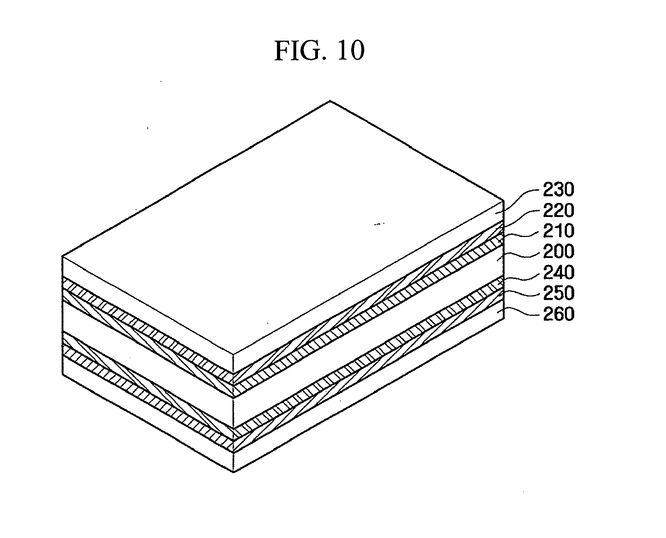

Next, referring to FIG. 10, a second intrinsic amorphous silicon layer 240, an amorphous silicon layer 250 of second conductivity type and a second TCO layer 260 are sequentially formed on the back surface of the crystal silicon layer 200 of second conductivity type. The second intrinsic amorphous silicon layer 240, the amorphous silicon layer 250 of second conductivity type and the second TCO layer 260 may also be formed using PECVD.

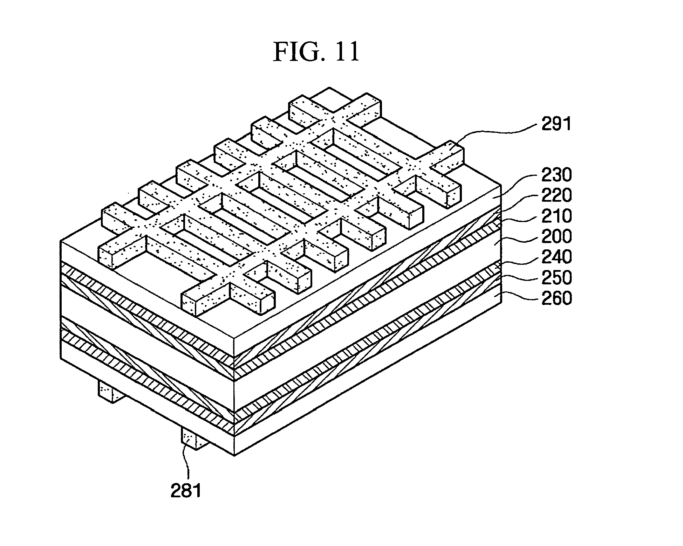

Referring to FIG. 11, conductive pastes 281 and 291 for forming a front surface electrode and a back surface electrode are coated on the front surface of the first TCO layer 230 and the back surface of the second TCO layer 260, respectively. Compositions of the conductive pastes 281 and 291 are not specifically limited, but they may include metal powder, glass frit, and a binder. The metal powder may include a metal having excellent electric conductivity and reflectivity, such as silver (Ag), aluminium (Al), titanium (Ti), alloys of these metals, or the like. The conductive pastes 281 and 291 may be coated on the front surface of the first TCO layer 230 and the back surface of the second TCO layer by, for example, a spin coating method, a slit coating, spray method, a screen printing method, an ink-jet method, a gravure printing method, an off-set printing method, or a dispensing method.

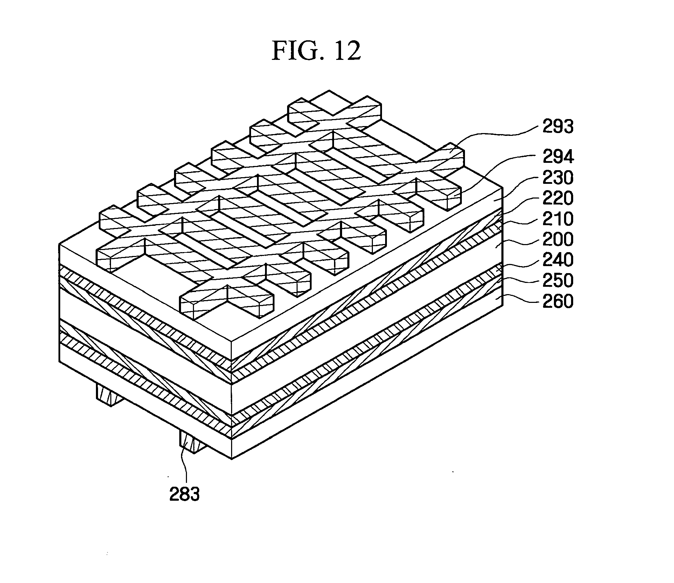

Referring to FIG. 12, metal layers 293 and 294 for forming a front surface electrode, and a metal layer 283 for forming a back surface electrode are formed by drying and heating the conductive pastes 281 and 291 at low temperature. The metal layers 293 and 294 for forming a front surface electrode may include the metal layer 293 for forming bus bars, and the metal layer 294 for forming finger lines. When the conductive pastes 281 and 291 are dried, a drying temperature may be approximately 2000 or less. The conductive pastes 281 and 291 may be dried or heated at low temperature by inserting the resultant structure having the conductive pastes 281 and 291 coated thereon into a processing chamber and elevating the temperature of the processing chamber.

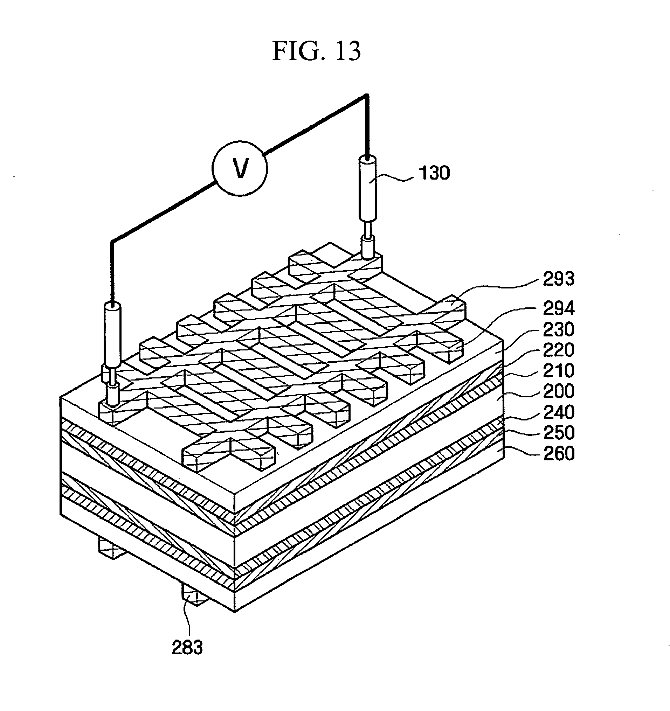

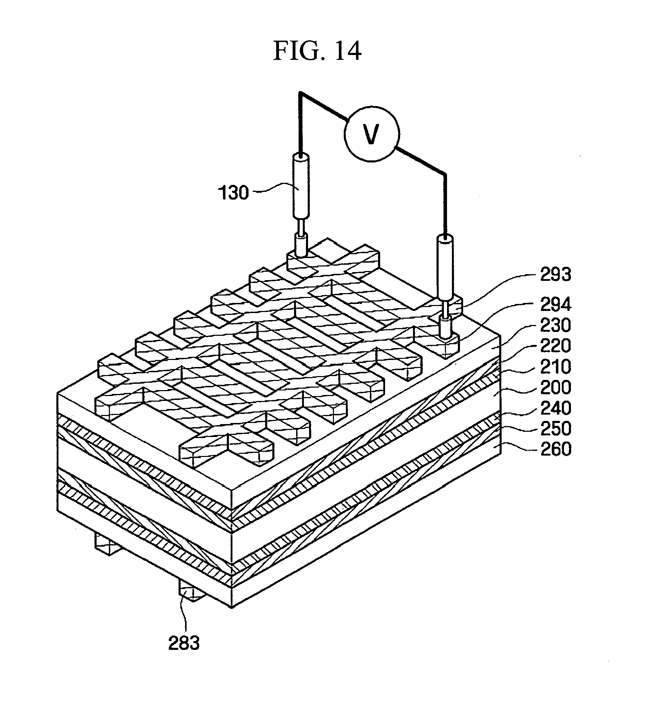

Referring to FIGS. 13 and 14, electric fields are applied to the metal layers 293 and 294 for forming a front surface electrode.

Specifically, referring to FIG. 13, the electric field is applied to the metal layer 293 for forming bus bars by allowing a probe 130 to contact both ends of the metal layer 293 and then applying a voltage (V) to the probe 130. Next, referring to FIG. 14, the electric field is applied to the metal layer 294 for forming finger lines by allowing a probe 130 to contact both ends of the metal layer 294 and then applying a voltage (V) to the probe 130. In applying the electric fields are applied to the metal layers 293 and 294 using the probe 130, the electric field applied to each of the metal layers 293 and 294 can be elaborately controlled.

If the electric fields are applied to the metal layers 293 and 294, current flows through the metal layers 293 and 294, generating joule heat. Then, the metal layers 293 and 294 are annealed by joule heating using the joule heat.

An annealing temperature of the metal layers 293 and 294 may be adjusted by adjusting the electric fields to the metal layers 293 and 294. The electric field to be applied to metal layer 120 to anneal the metal layer 120 at a desired temperature may vary according to the line widths, heights and lengths of the metal layers 293 and 294. For example, if the line widths of the metal layers 293 and 294 are approximately 4 mm, voltages applied to the metal layers 293 and 294 may be approximately 100 V or less, and currents applied to the metal layers 293 and 294 may be approximately 5 A or less.

The applying of the electric fields to the metal layers 293 and 294 may be performed for a very short time ranging from several microseconds (*µ*sec) to several milliseconds (msec). Here, the electric fields applied may be general direct-current (DC) power or pulsed DC power. Applying the pulsed DC is advantageous in that elaborate temperature controlling can be achieved and the amorphous silicon layers 210 and 220 formed under the metal layers 293 and 294 can be prevented from being damaged.

Referring to FIGS. 6, 13 and 14, bus bars 271 and finger lines 272 of the front surface electrode 270 are completed by annealing the metal layer 293 for forming bus bars and the metal layer 294 for forming finger lines by joule heating.

As described above, when an electrode is formed using conductive paste, as the conductive paste is annealed at a higher temperature, the resistance of the electrode tends to decrease. In the manufacture of the HIT solar cell illustrated in the present embodiment, however, when the temperature of the processing chamber exceeds approximately 200, the excess may cause crystallization of the amorphous silicon layers 210, 220, 240, and 250. If the amorphous silicon layers 210, 220, 240, and 250 are crystallized, defects may be caused to the HIT solar cell.

In the joule heating employed in the embodiment of the present invention, the metal layer 293 for forming bus bars and the metal layer 294 for forming finger lines are heated performed at a temperature in a range of approximately 300 to approximately 400 for a very short time ranging from several microseconds (*µ*sec) to several milliseconds (msec). In a case of using the joule heating, heat is applied to the metal layer 293 for forming bus bars and the metal layer 294 for forming finger lines only for a very short time ranging from several microseconds (*µ*sec) to several milliseconds (msec). Accordingly, it is possible to prevent the heat from being transferred to the amorphous silicon layer 220 of first conductivity type adjacent to the metal layer 293 for forming bus bars and the metal layer 294 for forming finger lines. Therefore, the resistance of the front surface electrode 270 can be reduced while preventing crystallization of the amorphous silicon layers 210 and 220. Meanwhile, in a case of using pulsed DC power when the electric fields are applied to the metal layers 293 and 294, since elaborate temperature controlling is easily achieved, crystallization of the amorphous silicon layers 210 and 220 formed under the metal layers 293 and 294 can be more advantageously prevented.

Meanwhile, an electric field is applied to the metal 283 for forming a back surface electrode in the same manner as the case where the electric fields are applied to the metal layers 293 and 294 for forming the front surface electrode, thereby reducing the resistance of the back surface electrode 280.

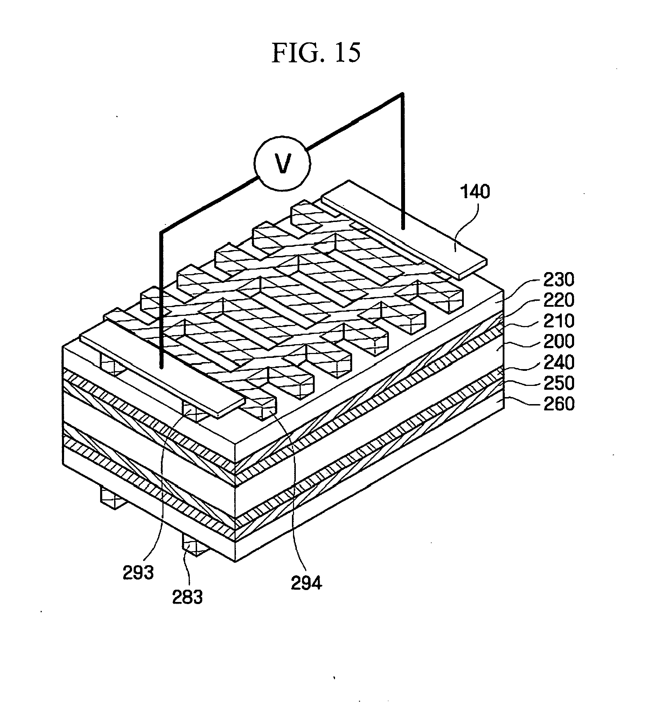

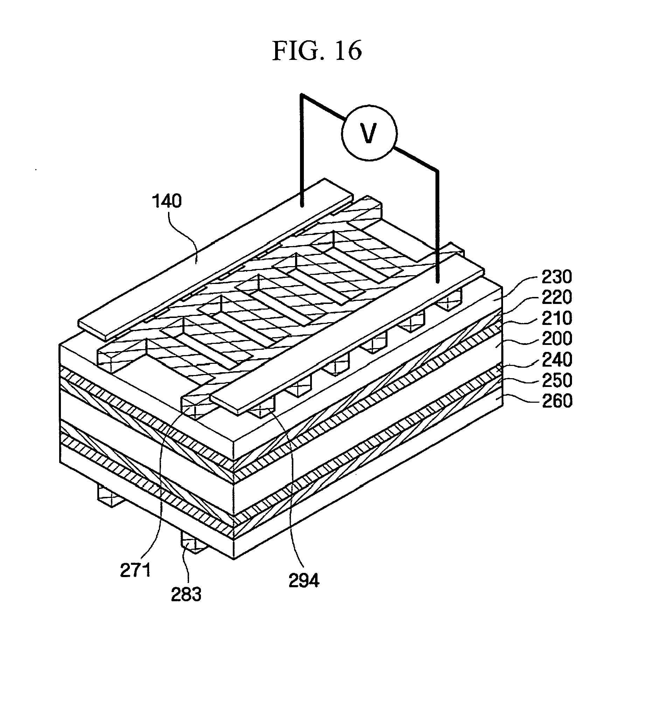

Now, a method of manufacturing a solar cell according to a second embodiment of the present invention will be described with reference to FIG. 6, FIGS. 9 through 12, and FIGS. 15 and 16. FIGS. 15 and 16 are perspective views illustrating a method of applying an electric field to a metal layer for forming a front surface electrode in a method of manufacturing a solar cell according to a second embodiment of the present invention.

The solar cell manufacturing method according to the second embodiment of the present invention is substantially the same as that according to the first embodiment of the present invention, except for the method of applying electric fields to metal layers, and the following description is based on differences between two embodiments.

Referring to FIG. 15, a metal plate 140 is allowed to contact both ends of a plurality of metal layers 293 for forming multiple bus bars over the metal layers 293, and a voltage (V) is applied to the metal plate 140, thereby applying an electric field to the metal layers 293 for forming multiple bus bars at the same time. Referring to FIG. 16, the metal plate 140 is allowed to contact both ends of a plurality of metal layers 294 for forming multiple finger lines over the metal layers 294, and a voltage (V) is applied to the metal plate 140, thereby applying an electric field to the metal layers 294at the same time. In a case where the electric field is applied to the metal layers 293 or 294 using the metal plate 140, the electric field can be applied to the plurality of metal layers 293 or 294 at the same time, thereby shortening a processing time.

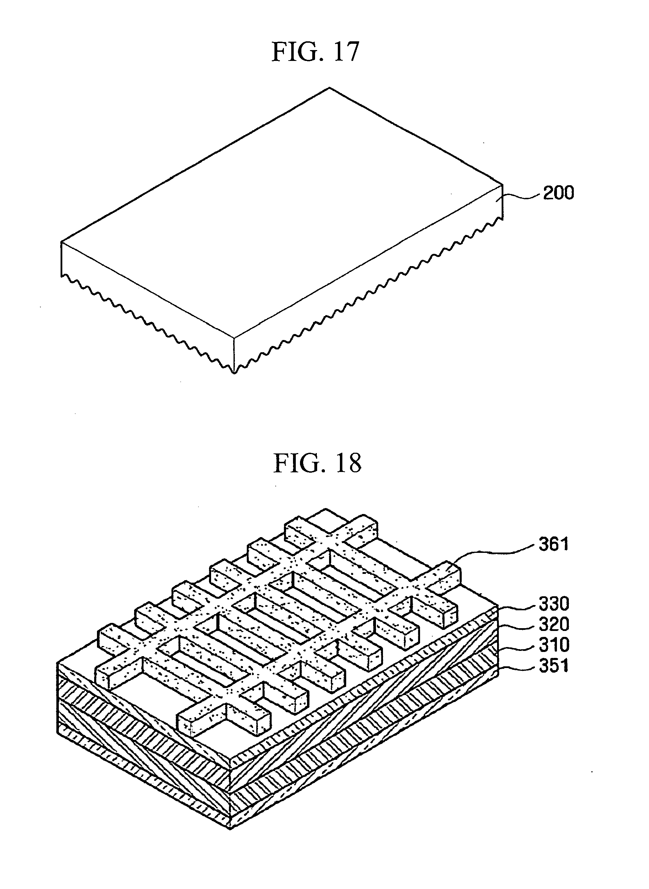

A method of manufacturing a solar cell according to a third embodiment of the present invention will now be described with reference to FIG. 7 and FIGS. 9 through 17. FIG. 17 is a perspective view illustrating a texturing structure formed on a back surface of a light absorbing layer in a method of manufacturing a solar cell according to a third embodiment of the present invention. The solar cell manufacturing method according to the third embodiment of the present invention is substantially the same as that according to the second embodiment of the present invention, except that a textured structure is formed on a back surface of a crystal silicon layer of second conductivity type, and the following description is based on differences between two embodiments.

Referring to FIG. 17, the forming of the textured structure on the back surface of the crystal silicon layer 200 of second conductivity type may be performed by etching using a known etching process. For example, the textured structure may be formed by dipping the crystal silicon layer 200 into a basic etchant solution such as tetramethyl ammonium hydroxide (TMAH), potassium hydroxide (KOH), or sodium hydroxide (NaOH). The subsequent processes may be performed by the solar cell manufacturing method shown in FIGS. 9 through 16.

A method of manufacturing a solar cell according to a fourth embodiment of the present invention will be described with reference to FIG. 8 and FIGS. 18 through 21. FIGS. 18 through 21 are perspective views illustrating the method of manufacturing the solar cell shown in FIG. 8.

Referring to FIG. 18, the crystal silicon layer 320 of second conductivity type is formed on the crystal silicon layer 310 of first conductivity type, and the anti-reflective layer 330 is formed on the crystal silicon layer 320 of second conductivity type.

Subsequently, conductive pastes 351 and 361 for forming a front surface electrode and a back surface electrode are coated on the front surface of the anti-reflective layer 330 and the back surface of the crystal silicon layer 310 of first conductivity type.

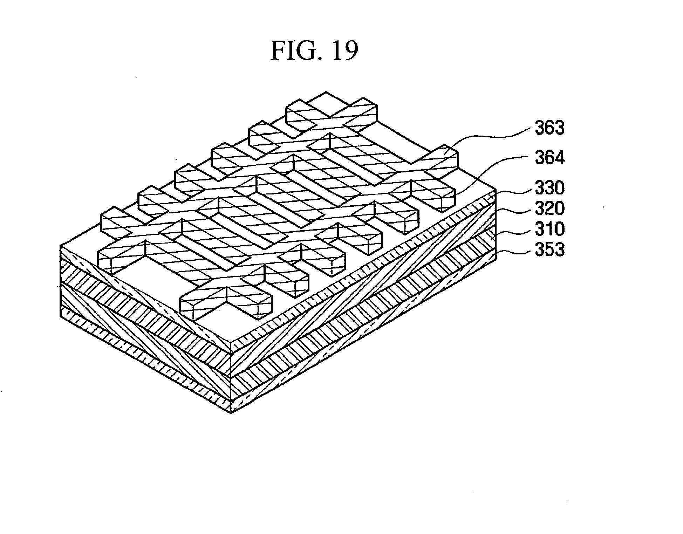

Next, referring to FIG. 19, metal layers 363 and 364 for forming a front surface electrode, and a metal layer 353 for forming a back surface electrode are formed by drying and heating the conductive pastes 351 and 361 at low temperature. The metal layers 363 and 364 for forming a front surface electrode may include the metal layer 363 for forming bus bars, and the metal layer 364 for forming finger lines. The conductive paste 361 may be dried or heated at low temperature by inserting the resultant structure having the conductive paste 361 coated thereon into a processing chamber and elevating the temperature of the processing chamber.

The metal layers 363 and 364 for forming a front surface electrode, and the metal layer 353 for forming a back surface electrode are formed by drying and heating the conductive pastes 351 and 361 at low temperature.

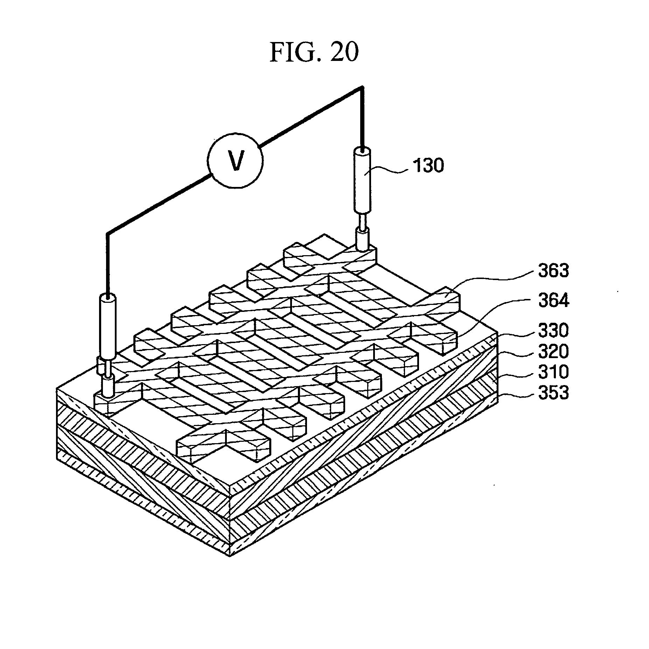

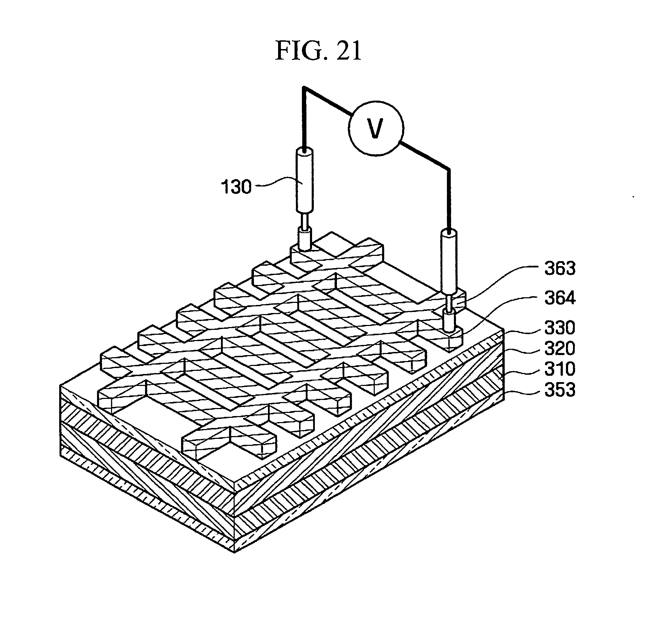

Referring to FIGS. 20 and 21, electric fields are applied to the metal layers 363 and 364 for forming a front surface electrode.

Specifically, referring to FIG. 20, the electric field is applied to the metal layer 363 for forming bus bars by allowing a probe 130 to contact both ends of the metal layer 363 and then applying a voltage (V) to the probe 130. Next, referring to FIG. 21, the electric field is applied to the metal layer 364 for forming finger lines by allowing a probe 130 to contact both ends of the metal layer 364 and then applying a voltage (V) to the probe 130.

If the electric fields are applied to the metal layers 363 and 364, currents may flow through the metal layers 363 and 364, generating joule heat. The metal layers 363 and 364 are annealed by joule heating using the joule heat. Here, the metal layers 363 and 364 may be annealed at a temperature of approximately 800 or higher by adjusting the electric fields applied to the metal layers 363 and 364. In this embodiment, the crystal silicon layers 310 and 320 are formed under the metal layers 363 and 364. Therefore, the annealing according to the current embodiment allows the metal layers 363 and 364 to be annealed at a higher temperature than in the previous embodiments.

Referring to FIGS. 8, 20 and 21, the bus bars 341 and the finger lines 342 of the front surface electrode 340 are completed by annealing the metal layer 363 for forming bus bars and the metal layer 364 for forming finger lines by joule heating.

Meanwhile, an electric field is also applied to the metal layer 353 for forming a back surface electrode in the same manner as in applying the electric fields to the metal layers 363 and 364 for forming a front surface electrode, thereby reducing the resistance of the back surface electrode 350.

While the present invention has been particularly shown and described with reference to exemplary embodiments thereof, it will be understood by those of ordinary skill in the art that various changes in form and details may be made therein without departing from the spirit and scope of the present invention as defined by the following claims. It is therefore desired that the present embodiments be considered in all respects as illustrative and not restrictive, reference being made to the appended claims rather than the foregoing description to indicate the scope of the invention.

## Claims

1. A method of forming an electrode comprising:
coating a conductive paste on a substrate;
drying the conductive paste at low temperature to form a metal layer; and
applying an electric field to the metal layer to anneal the metal layer by Joule heating.

2. The electrode forming method of claim 1, wherein the applying of the electric field to the metal layer comprises applying a separation of voltage to the metal layer.

3. The electrode forming method of claim2, wherein the applying of the separation of voltage to the metal layer comprises one of allowing a metal plate to contact both ends of the metal layer and applying a voltage to the metal plate, or allowing a probe to contact both ends of the metal layer.

4. The electrode forming method of claim 1, wherein the applying of the electric field to the metal layer comprises applying direct-current (DC) power to the metal layer.

5. The electrode forming method of claim 1, wherein the applying of the electric field to the metal layer comprises applying pulsed direct-current (DC) power to the metal layer.

6. A method of manufacturing a solar cell comprising:
coating conductive paste on a first surface of a substrate;
forming a metal layer by drying the conductive paste or heating the conductive paste at low temperature; and
forming a first electrode by annealing the metal layer by Joule heating using the metal layer by applying an electric field to the metal layer.

7. The solar cell manufacturing method of claim 6, wherein the applying of the electric field to the metal layer comprises allowing a probe to contact both ends of the metal layer and applying a voltage to the probe.

8. The solar cell manufacturing method of claim 6, wherein the applying of the electric field to the metal layer comprises allowing a metal plate to contact both ends of the metal layer and applying a voltage to the metal plate.

9. The solar cell manufacturing method of claim 6, wherein the applying of the electric field to the metal layer comprises applying direct-current (DC) power to the metal layer.

10. The solar cell manufacturing method of claim 6, wherein the applying of the electric field to the metal layer comprises applying pulsed direct-current (DC) power to the metal layer.

11. The solar cell manufacturing method of claim 6, wherein the first surface of the first surface of the crystal silicon layer is a light-receiving surface of the sunlight.

12. The solar cell manufacturing method of claim 11, wherein the crystal silicon layer is a crystal silicon layer of second conductivity type.

13. The solar cell manufacturing method of claim 12, further comprising forming a first intrinsic amorphous silicon layer and amorphous silicon layer of first conductivity type between the crystal silicon layer of second conductivity type and the first electrode.

14. The solar cell manufacturing method of claim 13, further comprising forming a first TCO layer between the amorphous silicon layer of first conductivity type and the first electrode, and the conductive paste is coated on the first TCO layer.

15. The solar cell manufacturing method of claim 14, wherein the first TCO layer is made of indium tin oxide (ITO), indium zinc oxide (IZO), indium tin zinc oxide (ITZO), antimony tin oxide (ATO), or aluminum-doped zinc oxide (AZO).

16. The solar cell manufacturing method of claim 13, wherein, the annealing of the metal layer by Joule heating comprises annealing the metal layer at a temperature in a range of approximately 300°C to approximately 400°C.

17. The solar cell manufacturing method of claim 13, wherein the drying or heating the conductive paste at low temperature is performed at a temperature of approximately 200°C or less.

18. The solar cell manufacturing method of claim 13, further comprising forming a second electrode on a second surface of the crystal silicon layer of second conductivity type facing the first surface of the crystal silicon layer of second conductivity type.

19. The solar cell manufacturing method of claim 18, further comprising forming a second intrinsic amorphous silicon layer and an amorphous silicon layer of second conductivity type between the crystal silicon layer of second conductivity type and the second electrode.

20. The solar cell manufacturing method of claim 19, further comprising forming a second TCO layer between the amorphous silicon layer of second conductivity type and the second electrode.

21. The solar cell manufacturing method of claim 6, further comprising a textured structure on one surface of the crystal silicon layer.
